# EUROPÄISCHE PATENTANMELDUNG

(11) **EP 2 485 275 A1**
(43) Veröffentlichungstag der Anmeldung: **08.08.2012**
(21) Anmeldenummer: 12152626.3
(22) Anmeldetag: 26.01.2012
(51) Int. Cl.: H01L 31/048

(54) **Photovoltaisches Solarmodul mit einer Anschlussdose**

(30) Priorität: 03.02.2011 CH 1982011
(71) Anmelder: Multi-Holding AG, 4123 Allschwil (CH)
(72) Erfinder: Torma, Andreas, 46284 Dorsten (DE); Klemm, Jürgen, 4123 Allschwil 1 (CH)
(74) Vertreter: Frischknecht, Harry Ralph

(57) **Zusammenfassung**

Ein photovoltaisches Solarmodul umfasst eine Photovoltaikpaneele (1) und mindestens eine Anschlussdose (2), wobei die Photovoltaikpaneele (1) mindestens ein Solarglas (3), eine unter dem Solarglas angeordnete Solarzelle (4) zur Gewinnung von elektrischer Energie und elektrische Leiter (6) zur Wegführung der Energie umfasst, wobei die Anschlussdose (2) einen externen Kontaktabschnitt (10) zur Verbindung der Anschlussdose (2) mit externen Verbindungselementen zur Wegführung der elektrischen Energie umfasst, und wobei der externe Kontaktabschnitt (10) der Anschlussdose (2) mit dem elektrischen Leiter (6) der Photovoltaikpaneele (1) über einen internen Kontaktabschnitt (12) elektrisch in Verbindung steht. Der interne Kontaktabschnitt (12) umfasst ein mit elektrischen Leiter (6) in Verbindung stehendes erstes Kontaktelement (13) und ein mit dem externen Kontaktabschnitt (10) in Verbindung stehendes zweites Kontaktelement (14), wobei die elektrisch leitende Verbindung zwischen dem ersten und dem zweiten Kontaktelement (13, 14) durch eine Buchsen-Stecker-Verbindung mit einem Buchsenelement (15) und einem Steckerelement (16) bereitgestellt wird, und wobei die Buchsen-Stecker-Verbindung (15, 16) durch ein mechanisches Sicherungselement (18, 19) gegen unbeabsichtigtes Trennen der Verbindung gesichert ist.

## Beschreibung

### TECHNISCHES GEBIET

Die vorliegende Erfindung betrifft ein photovoltaisches Solarmodul mit einer Anschlussdose nach dem Oberbegriff von Anspruch 1.

### STAND DER TECHNIK

Aus dem Stand der Technik sind Anschlussdosen für Photovoltaikmodule bekannt. Solche Anschlussdosen dienen der Aufnahme einer Bypass-Diode, so dass bei teilweise abgeschalteter Solarzelle bzw. Photovoltaikpaneelen die damit verbundenen Problematiken verhindert werden können.

Beispielsweise zeigt die WO 2009/062326 eine derartige Anschlussdose. Solche Anschlussdosen werden typischerweise mit einem Klebstoff mit der Oberfläche der Solarpaneele verbunden. Dieser Klebstoff muss gewissen Anforderungen bezüglich Langlebigkeit, Temperaturschwankungen, und auch bezüglich mechanischen Einflüssen, beispielsweise gegen Scherkräfte etc., entsprechen.

Obwohl mit der Anschlussdose nach WO 2009/62326 ausserordentlich gute Resultate erzielt wurden, es ist mit der zunehmenden Anzahl von produzierten Photovoltaikmodulen ein Bedürfnis geworden, diese noch effizienter herstellen zu können. Insbesondere die elektrische Verbindung zwischen Photovoltaikmodul und Anschlussdose verzögert bei Lösungen aus dem Stand der Technik die Montagezeit erheblich.

### DARSTELLUNG DER ERFINDUNG

Ausgehend von diesem Stand der Technik liegt der Erfindung die Aufgabe zugrunde, ein photovoltaisches Solarmodul mit einer Anschlussdose und einer Photovoltaikpaneele anzugeben, welches die Nachteile des Standes der Technik überwindet.

Eine solche Aufgabe wird durch ein photovoltaisches Solarmodul mit einer Anschlussdose nach Anspruch 1 gelöst. Demgemäss umfasst ein photovoltaisches Solarmodul eine Photovoltaikpaneele und mindestens eine Anschlussdose, wobei die Photovoltaikpaneele mindestens ein Solarglas, eine unter dem Solarglas angeordnete Solarzelle zur Gewinnung von elektrischer Energie und elektrische Leiter zur Wegführung der Energie umfasst, und wobei die Anschlussdose mindestens einen externen Kontaktabschnitt zur Verbindung der Anschlussdose mit externen Verbindungselementen zur Wegführung der elektrischen Energie umfasst. Der externe Kontaktabschnitt der Anschlussdose steht mit dem elektrischen Leiter der Photovoltaikpaneele über einen internen Kontaktabschnitt elektrisch in Verbindung. Der interne Kontaktabschnitt umfasst ein mit elektrischen Leitern in Verbindung stehendes erstes Kontaktelement und ein mit dem externen Kontaktabschnitt in Verbindung stehendes zweites Kontaktelement, wobei die elektrisch leitende Verbindung zwischen dem ersten und dem zweiten Kontaktelement durch eine Buchsen-Stecker-Verbindung mit einem Buchsenelement und einem Steckerelement bereitgestellt wird. Die Buchsen-Stecker-Verbindung ist durch ein mechanisches Sicherungselement gegen unbeabsichtigtes Trennen der Verbindung gesichert ist.

Durch das mechanische Sicherungselement kann die Verbindung zwischen Anschlussdose und Photovoltaikpaneele weiter verbessert werden. Zudem verbessert die Buchsen-Stecker-Verbindung die mechanische Stabilität und Festigkeit der Verbindung zwischen Photovoltaikmodul und Anschlussdose.

Vorzugsweise steht das Buchsenelement in Kontakt mit der Solarpaneele und das Steckerelement steht in Kontakt mit der Anschlussdose. Diese Anordnung hat den Vorteil, dass eine einfache Positionierung des Steckerelementes im Buchsenelement möglich ist.

Vorzugsweise sind pro Anschlussdose und Photovoltaikpaneele zwei Buchsen-Stecker-Verbindungen vorgesehen.

Vorzugsweise ist das mechanische Sicherungselement vom Buchsenelement und/oder vom Steckerelement separat ausgebildet, wobei das Sicherungselement vorzugsweise zwischen Buchsenelement und Steckerelement zu liegen kommt, wenn das Steckerelement im Buchsenelement eingeführt ist.

Das Sicherungselement stellt zwischen dem Buchsenelement und dem Steckerelement vorzugsweise eine formschlüssige Verbindung und/oder eine kraftschlüssige Verbindung bereit.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine geschnittene Detailansicht durch eine photovoltaisches Solarmodul bzw. ein Photovoltaikmodul mit einer Photovoltaikpaneele und einer Anschlussdose im getrennten Zustand;
- Fig. 2: eine Detailansicht der elektrischen Verbindung zwischen der Anschlussdose und dem Photovoltaikmodul nach Figur 1;
- Fig. 3: die Schnittansicht nach Figur 1 im zusammengefügten Zustand;
- Fig. 4: eine Detailansicht der Figur 3;
- Fig. 5: eine perspektivische Ansicht eines Klemmelementes zum Einsatz im photovoltaischen Solarmodul;
- Fig. 6: eine Seitenansicht des Klemmelementes; und
- Fig. 7: eine Schnittansicht entlang der Linie A-A der Figur 6.

### BESCHREIBUNG BEVORZUGTER AUSFÜHRUNGSFORMEN

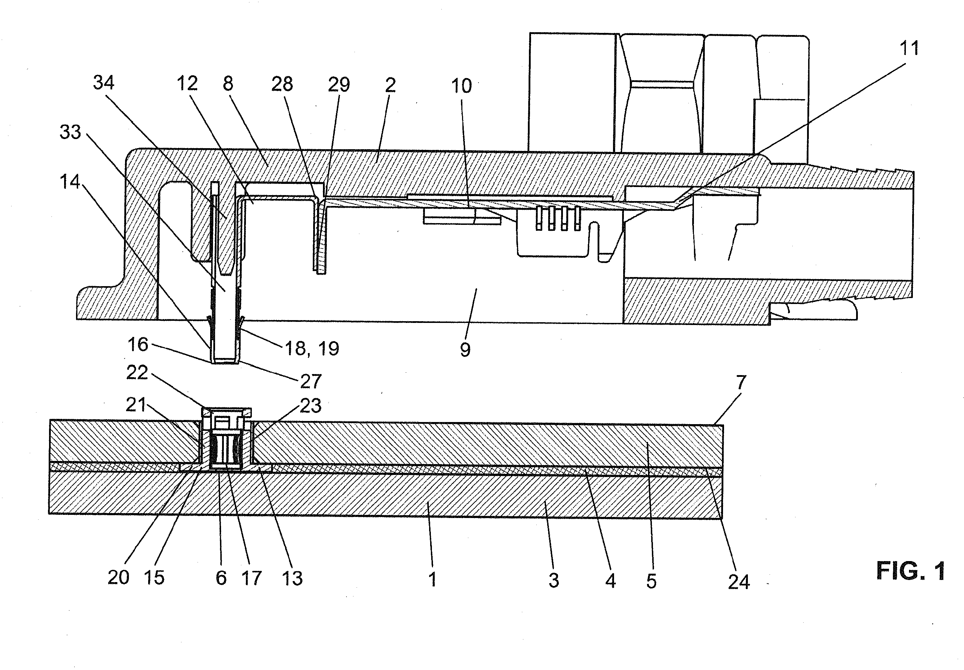

In der Figur 1 wird eine Schnittansicht eines Teils eines Photovoltaikmoduls P gezeigt. Das Photovoltaikmodul umfasst eine Photovoltaikpaneele 1 und mindestens eine Anschlussdose 2. Photovoltaikpaneele 1 und Anschlussdose 2 sind hier im getrennten Zustand gezeigt. Die Photovoltaikpaneele 1 dient der Erzeugung von elektrischer Energie und die Anschlussdose 2 dient der Wegführung dieser Energie zu entsprechenden Verbrauchern beziehungsweise zur Serie- oder Parallelschaltung mit anderen Photovoltaikmodulen.

Die Photovoltaikpaneele 1 umfasst in der vorliegenden Ausführungsform ein unteres Solarglas 3, eine Zwischenschicht 4 und ein oberes Solarglas 5. Die Zwischenschicht umfasst die Solarzelle zur Gewinnung von elektrischer Energie, elektrische Leiter 6 zur Wegführung der Energie, sowie teilweise eine Kunststoffschicht als Distanzhalter und Isolator. Das obere Solarglas 5 umfasst weiter eine Oberfläche 7, auf welcher die Anschlussdose 2 aufliegt. Gegenüberliegend der Oberfläche 7 steht das obere Solarglas 5 mit einer Oberfläche 24 mit der Zwischenschicht 4 in Verbindung.

Die Anschlussdose 2 umfasst hier ein Anschlussdosengehäuse 8, welches einen Innenraum 9 begrenzt. Im Innenraum 9 ist ein externer Kontaktabschnitt 10 angeordnet, welcher mit dem elektrischen Leiter 6 indirekt in Verbindung steht. Der externe Kontaktabschnitt 10 dient im wesentlichen zur Wegführung der elektrischen Energie. Hierfür umfasst der externe Kontaktabschnitt 6 Anschlusselemente 11, welche mit externen Verbindungselementen, wie beispielsweise mit dem Stecker oder der Buchse eines Kabels verbunden werden können. Die Anschlusselemente 11 umfassen im wesentlichen den elektrischen Strom leitenden Elemente und können als Steckerelement und/oder als Buchsenelement ausgebildet sein. Weiter können die Anschlusselemente 11 zusätzlich mechanische Sicherungsmittel aufweisen, so dass ein externes Verbindungselement mechanisch gegen unbeabsichtigtes Trennen gesichert werden kann.

Der externe Kontaktabschnitt 11 steht mit dem elektrischen Leiter 6 über einen internen Kontaktabschnitt 12 elektrisch in Verbindung. Mit anderen Worten kann gesagt werden, dass der interne Kontaktabschnitt 12 im Wesentlichen die Verbindung zwischen dem Leiterkreis der Photovoltaikpaneele 1 und demjenigen der Anschlussdose 2 bereitstellt. Die Trennung zwischen dem internen Kontaktabschnitt 12 und dem externen Kontaktabschnitt 10 kann in den Figuren 1 bis 4 beispielsweise anhand der Verbindungsstelle 29 erkannt werden, welche untenstehend noch weiter beschrieben wird.

Der interne Kontaktabschnitt 12 umfasst ein erstes mit dem elektrischen Leiter 6 in Verbindung stehendes Kontaktelement 13 und ein zweites mit dem externen Kontaktabschnitt 11 in Verbindung stehendes zweites Kontaktelement 14. Die Verbindung zwischen dem ersten Kontaktelement 13 und dem zweiten Kontaktelement 14 wird durch eine Buchsen-Stecker-Verbindung bereitgestellt. Diese Verbindung umfasst ein Buchsenelement 15 und ein mit dem Buchsenelement 15 elektrisch in Verbindung bringbares Steckerelement 16. Bevorzugterweise ist zwischen dem Buchsenelement 15 und dem Steckerelement 16 ein Kontaktelement 17, wie beispielsweise eine Kontaktlamelle, zur Vermittlung eines elektrischen Kontaktes zwischen Buchsenelement 15 und Steckerelement 16 angeordnet. Es kann somit gesagt werden, dass die Anschlussdose 2 elektrisch mit der Photovoltaikpaneele 1 über eine Buchsen-Stecker-Verbindung elektrisch verbindbar ist.

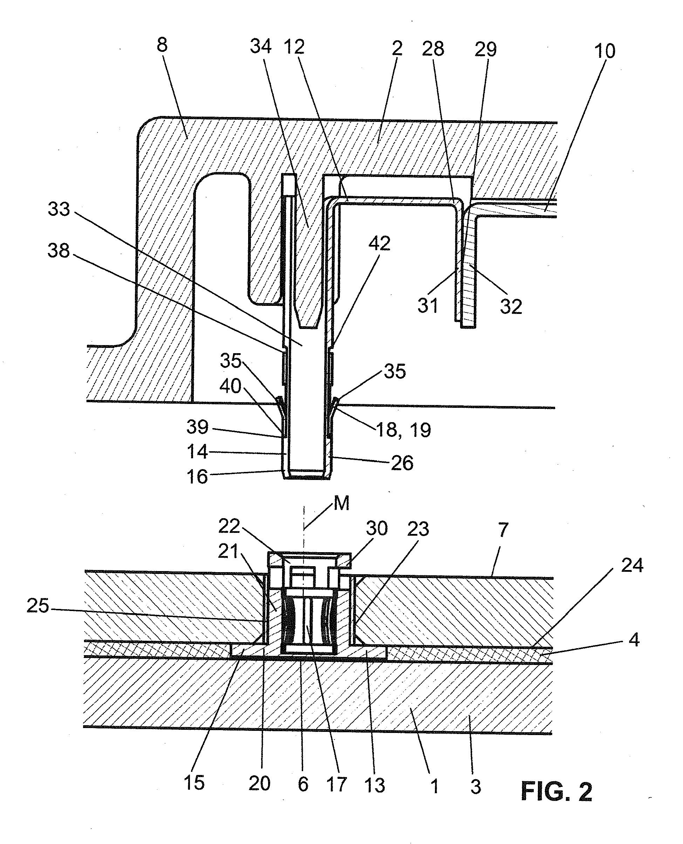

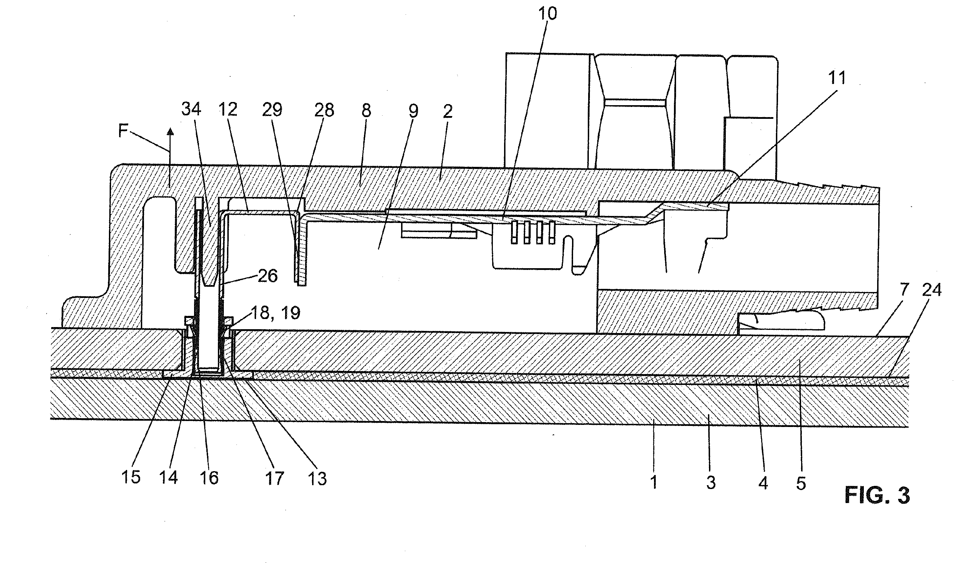

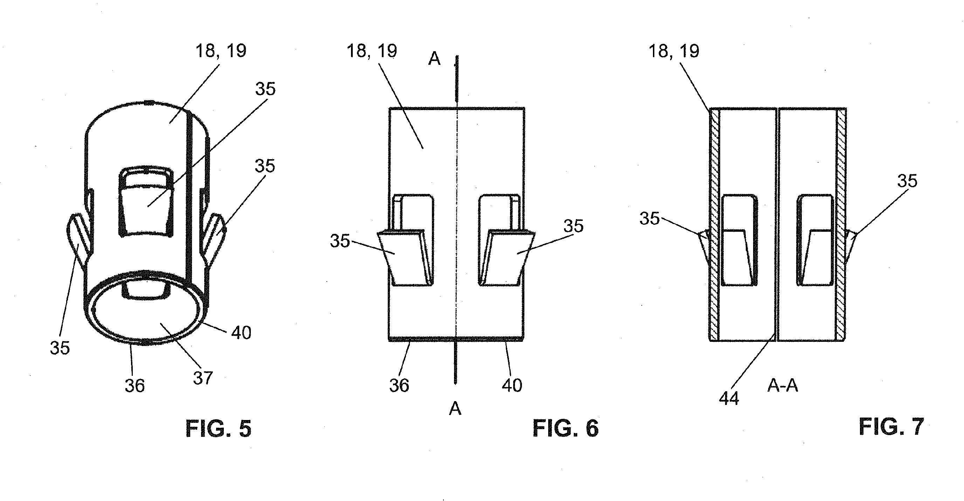

Diese Buchsen-Stecker-Verbindung sorgt zudem auch für eine mechanische Verbindung zwischen Photovoltaikpaneele 1 und Anschlussdose 2. Die mechanische Verbindung wird weiter durch ein mechanisches Sicherungselement 18 gegen unbeabsichtigtes Trennen der Verbindung gesichert. Das mechanische Sicherungselement 18 ist separat vom Buchsenelement 15 bzw. vom Steckerelement 16 bzw. von der Kontaktlamelle 17 ausgebildet. Im getrennten Zustand kann das Sicherungselement 18 entweder auf dem Steckerelement 16, wie in den Figuren 1 und 2 gezeigt, oder im Buchsenelement 15 vormontiert sein. Das mechanische Sicherungselement 18 hat den Vorteil, dass abgesehen von der Verbindung zwischen Buchsenelement 15 und Steckerelement 16 ein weiteres Element bereitgestellt wird, welches diese Verbindung gegen das unbeabsichtigte Lösen sichert bzw. die Verbindung zwischen Buchsenelement 15 und Steckerelement 16 unterstützt. Folglich verhindert das mechanische Sicherungselement 18 eine Ausziehbewegung zwischen Buchsenelement 15 und Steckerelement 16 gegen Steckrichtung. Mit anderen Worten kann gesagt werden, dass das Sicherungselement 18 einen Anschlag gegen eine Auszugskraft F entgegen der Steckrichtung bereitstellt. Diese Kraft F wird in der Figur 3 gezeigt. Das mechanische Sicherungselement 18 ist hier als Federklipp 19 ausgebildet und wird dann mit den Figuren 5 bis 7 weiter erläutert.

Wie von der Figur 2 erkannt werden kann, steht das Buchsenelement 15 hier in Verbindung mit der Photovoltaikpaneele 1. Das Buchsenelement 15 ist vorzugsweise in die Photovoltaikpaneele 1 einlaminiert. Weiter steht das Buchsenelement 15 über eine stoffschlüssige Verbindung mit dem elektrischen Leiter 6 der Photovoltaikpaneele 1 in Verbindung. Die stoffschlüssige Verbindung ist dabei elektrisch leitend ausgebildet und kann beispielsweise durch einen Löt- oder einen Schweissvorgang ausgeführt sein.

Das Buchsenelement 15 ist in der vorliegenden Ausführungsform im Wesentlichen hohlzylindrisch und rotationssymmetrisch zu einer Mittelachse M ausgebildet und umfasst einen Flanschabschnitt 20 und einen sich dem Flanschabschnitt 20 anschliessenden Buchsenabschnitt 21. In dem Buchsenabschnitt 21 erstreckt sich eine Aufnahmeöffnung 22 entlang der Mittelachse M, wobei diese Aufnahmeöffnung der Aufnahme des Steckerelements 16 dient. Über den Flanschabschnitt 20 steht das Buchsenelement 15 mit dem elektrischen Leiter 6 in Verbindung und mit dem Buchsenabschnitt 21 ragt das Buchsenelement 15 durch eine Öffnung 23 durch das obere Solarglas 5. Der Flanschabschnitt 20 erstreckt sich im wesentlichen parallel zum und zwischen dem oberen Solarglas 5 und dem unteren Solarglas 3 in der Zwischenschicht 4.

Der Flanschabschnitt 20 weist vorzugsweise eine grössere Ausdehnung auf, als die Öffnung 23, so dass der Flanschabschnitt 20 zusätzlich an der Oberfläche 24, welche zur Zwischenschicht 4 zugewandt ist, ansteht. Folglich wirkt der Flanschabschnitt 20 zusätzlich als Anschlagselement gegen eine Auszugskraft F in Richtung der Mittelachse M. Wie in der Figur 2 weiter erkannt werden kann, steht der Flanschabschnitt 20 vorzugsweise in direktem Kontakt auf der Oberfläche 24 des oberen Solarglases 5. Gegen das untere Solarglas 3 ist der Flanschabschnitt 20 hier durch Teile der Zwischenschicht 4 und des elektrischen Leiters getrennt oder kann ebenfalls direkt mit dem unteren Solarglas in Verbindung stehen.

Zwischen dem Buchsenabschnitt 21 und der Öffnung 23 ist vorzugsweise eine Kunststoffschicht 25 angeordnet. Die Kunststoffschicht 25 besteht vorzugsweise aus einem Kunststoff ausgewählt aus der Gruppe der Copolymere, wie beispielsweise Ethylenvinylacetat (EVA) angeordnet. Diese Kunststoffschicht 25 hat den Vorteil, dass allfällige Wärmedehnungen nicht direkt auf den Buchsenabschnitt 21 wirken, sondern von dieser Kunststoffschicht 25 aufgenommen werden und dient zudem als Abdichtung der Verbindungsstelle zwischen Buchsenabschnitt 21 und Öffnung 23.

Das Buchsenelement 15 erstreckt sich mit dem Buchsenabschnitt 21 vorzugsweise über die Oberfläche 7 des oberen Solarglases 5. Folglich hebt sich das Buchsenelement 15 von dieser Oberfläche 7 teilweise ab, was dem Installateur erlaubt, die entsprechenden Anschlussstellen besonders gut zu erkennen. Zudem hat das Überstehen den Vorteil, dass die Verbindung zwischen Sicherungselement 18 und Buchsenelement 15, welche untenstehend erläutert wird, im Revisionsfall zugänglich ist.

Das Steckerelement 16 ist hier als zylindrischer Kontaktstift 26 ausgebildet. Dieser zylindrische Kontaktstift 26 kann dabei mit einem ersten Ende 27 in den Buchsenabschnitt 21 eingeschoben werden und über die Kontaktlamelle 17 wird ein elektrischer Kontakt zwischen Buchsenelement 15 und Steckerelement 16 vermittelt.

Der Kontaktstift 26 steht mit dem zweiten Ende 28 mit mindestens einem Funktionselement im Innenraum der Anschlussdose in elektrisch leitender Verbindung. Hierfür wird die Verbindungsstelle 29 vorgesehen. Das Funktionselement kann beispielsweise eine elektrische Verbindung mit dem externen Kontaktabschnitt 10 sein oder aber ein Bypassdiode, welche mit dem externen Kontaktabschnitt 10 in Verbindung steht. Alternativ können auch andere elektronischen oder elektrischen Steuerungselemente im Innenraum 9 des Anschlussdosengehäuses 8 angeordnet sein, welche mit dem Kontaktstift 20 beziehungsweise mit dem Steckerelement 16 und dem externen Kontaktabschnitt 10 elektrisch leitend in Verbindung stehen. Mit diesen Funktionselementen kann die Funktionsweise der Anschlussdose und die Verschaltung mit weiteren Photovoltaikmodulen gesteuert werden.

Der Kontaktstift 26 bzw. das Steckerelement 16 kann aus einem Vollkörper bestehen oder, wie in der vorliegenden Ausführungsform gezeigt, aus einem gerollten Metallblech hergestellt sein, wobei der Kontaktstift dann einen zylindrischen Innenraum 33 aufweist. Im letzteren Fall kann das Steckerelement 16 auch noch über Kontaktlaschen 31 verfügen, welche mit dem externen Kontaktabschnitt 10 bzw. mit den elektrischen Funktionselementen in Verbindung stehen. Die Kontaktlasche 31 entspricht im wesentlichen dem zweiten Ende 28. Die Kontaktlasche 31 steht hier mit einer entsprechenden Kontaktlasche 32 des externen Kontaktabschnittes 10 in Verbindung. Die beiden Kontaktlaschen 31, 32 verlaufen im verbundenen Zustand parallel zueinander.

Vorzugsweise ist das Steckerelement 16 beziehungsweise der Kontaktstift 26 fest im Anschlussdosengehäuse gelagert. Unter einer festen Lagerung wird verstanden, dass bei einer Krafteinwirkung keine Verschiebung zwischen Steckerelement 16 und Anschlussdosengehäuse 8 möglich ist. Somit wird die Anschlussdose steckbar mit der Photovoltaikpaneele verbindbar.

In der vorliegenden Ausführungsform steht das Steckerelement 16 über seinen zylindrischen Innenraum 33 mit einem vom Anschlussdosengehäuse abstehenden Stift 34 in Verbindung. Das Steckerelement 16 kann beispielsweise zum Stift 34 geklebt werden.

In der Folge wird nun das Sicherungselement 18 und dessen Funktionsweise weiter erläutert.

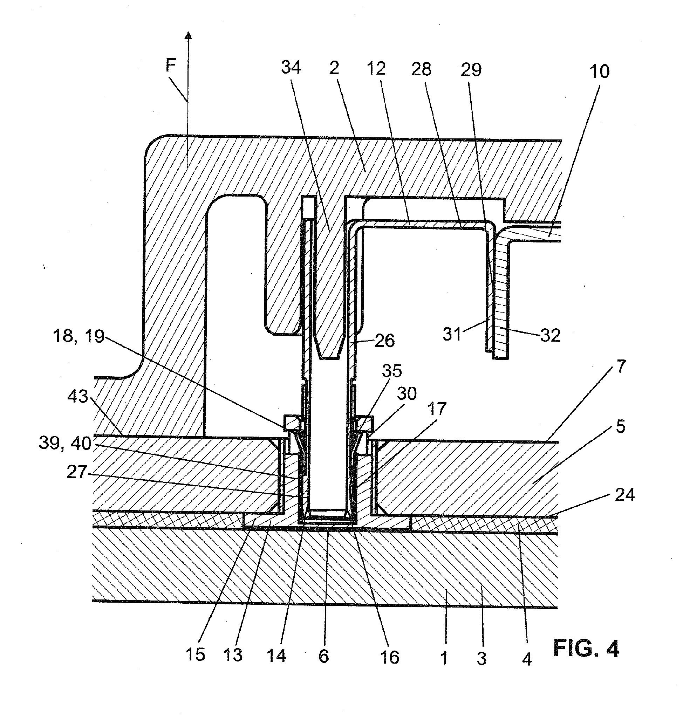

Von den Figuren 3 und 4 kann erkannt werden, dass das Sicherungselement 18, hier in der Gestalt eines Federklips 19, im Bereich des Buchsenabschnittes 21 zu liegen kommt und dort das Steckerelement 16 mit dem Buchsenelement 15 mechanisch verbinden. Letztendlich verbindet das Sicherungselement 18 die Anschlussdose 2 mit der Photovoltaikpaneele 1. Das Sicherungselement 18, 19 steht dabei einerseits mit dem Buchsenelement 15 und andererseits mit dem Steckerelement 16 in Verbindung und liegt zwischen diesen beiden Elementen 15, 16.

Das Sicherungselement 18 wird in den Figuren 5 bis 7 im Detail gezeigt. Das Sicherungselement 18 hat im wesentlichen die Form eines Hohlzylinders mit einer Seitenwand 36, welche einen Innenraum 37 begrenzt. Von der Seitenwand 36 stehen die Einhakabschnitte 35 vom Innenraum 37 gesehen nach aussen weg. Diese Einhakabschnitte 35 ragen dann in die Halterungsöffnungen 30 am Buchsenelement 15 ein. Die Einhakabschnitte 35 sind federnd ausgebildet, so dass diese nach einer Krafteinwirkung wieder in die Ursprungsstellung zurückkehren. Eine durch die Seitenwand 36 bereitgestellte Stirnfläche 40 stellt dabei eine Anschlagsfläche für das Steckerelement 16 bereit. Die Seitenwand 36 ist hier durch einen in Längsrichtung verlaufenden Ausschnitt 44 getrennt, was eine einfache Vor-Montage auf dem Steckerelement 16 bzw. dem Kontaktstift 26 erlaubt.

Das Sicherungselement 18 ist vorzugsweise aus einem metallischen Werkstoff hergestellt, kann aber auch aus Kunststoff sein.

Mit Hilfe der Figuren 1 und 2 wird nun die Verbindung zwischen Steckerelement 16 und Sicherungselement 18 erläutert. Das Steckerelement 16 umfasst für die Aufnahme des Sicherungselementes 18 weiter eine umlaufende Ausnehmung 38. Die Ausnehmung 38 stellt dabei eine Verringerung des Aussendurchmessers des Steckerelementes 16 dar und stellt für das Sicherungselement 18 eine Anschlagsfläche 39 bereit, wobei die Anschlagsfläche 39 mit der Anschlagsfläche 40 des Sicherungselementes 18 in Kontakt steht. Weiter stellt die Ausnehmung 38 eine hintere Anschlagsfläche 42 bereit, welche beim Einschieben des Steckerelementes 16 in das Buchsenelement 15 als Anschlag für das Sicherungselement 18 dient.

Für die Verbindung zwischen Sicherungselement 18 und Buchsenelement 15 erstrecken sich mindestens eine, hier vier Halterungsöffnungen 30 von der Aufnahmeöffnung 22 senkrecht zur Mittelachse M gesehen durch das Buchsenelement 21. Diese Halterungsöffnungen 30 dienen der Aufnahme von Einhakabschnitten 35 des Sicherungselementes 18 im zusammengefügten Zustand.

Beim Einführen des Steckerelementes 16 in das Buchsenelement 15 werden die Einhakabschnitte 35 durch die Aufnahmeöffnung 22 federnd gegen das Steckerelement 16 gedrückt. Dabei steht das Sicherungselement 18 an der hinteren Anschlagsfläche 42 and. Sobald das Steckerelement 16 soweit in das Buchsenelement 15 eingeschoben wurden, dass die Einhakabschnitte 35 auf die Höhe der Halterungsöffnungen 30 zu liegen kommt, so bewegen sich die Einhakabschnitte 35 aufgrund der federnden Ausbildung in die Halterungsöffnungen 30 und haken somit in den Halterungsöffnungen 30 ein.

In den Figuren 3 und 4 wird die zusammengefügte Situation gezeigt, wobei hier gut erkannt werden kann, dass die Einhakabschnitte 35 in die Halterungsöffnungen 30 einragen.

Wenn nun also eine Auszugskraft F auf das Steckerelement 16 wirkt, so wird diese Kraft durch das Sicherungselement 18 aufgenommen. Die Kraft wird dann über die Anschlagsfläche 39 auf die Anschlagsfläche 40 des Sicherungselementes 18 übertragen, wobei das Sicherungselement 18 diese Kraft über die Einhakabschnitte 35 und die Halterungsöffnungen 30 auf das Buchsenelement 15 überträgt.

In den Figuren 3 und 4 wird auch der Überstand des Buchsenelementes 15 über die Oberfläche 7 des Solarglases 5 gut gezeigt. Vorzugsweise sind die Halterungsöffnungen 30 derart angeordnet, dass diese über der Oberfläche 7 zugänglich sind. Somit ist die Verbindung zwischen Buchsenelement 15 und Steckerelement 16 durch das Sicherungselement 18 von aussen zugänglich und kann durch den Einsatz eines Werkzeuges getrennt werden. Dabei kann ein Werkzeug durch einen Spalt 43 zwischen Anschlussdose 2 und Solarglas 5 zu diesem Bereich geführt werden. Mit dem Werkzeug können dann die Einhakabschnitte 35 aus den Hälterungsöffnungen 30 gedrückt werden, so dass die mechanische Sicherungsverbindung zwischen Buchsenelement 15 und Steckerelement 16 aufgehoben werden kann und die Anschlussdose 2 von der Solarpaneele 1 entfernt werden kann.

In weiteren hier nicht gezeigten Ausführungsformen sind auch andere Ausbildungen von mechanischen Sicherungselementen denkbar. Beispielsweise wäre es denkbar, dass das Sicherungselement als Klemmelement ausgebildet ist, welche das Steckerelement mit einer Reibungskraft klemmt.

Mit Bezug zu Figur 1 wird an dieser Stelle noch angemerkt, dass das Anschlussdosengehäuse 8 vorzugsweise über eine Klebeverbindung mit der Oberfläche 7 des Solarglases verbunden wird. Vorzugsweise ist die Klebeverbindung als Silikonraupe ausgebildet, welche zugleich den Spalt 43 zwischen Anschlussdosengehäuse 8 und Oberfläche 7 abdichtet.

Im Lichte der oben genannten Beschreibung sei hier angemerkt, dass pro Anschlussdose 2 jeweils zwei Stiftelemente 16 vorhanden sind, welche in zwei mit der Photovoltaikpaneele in Verbindung stehende Buchsenelemente 15 eingreifen.

Zusammenfassend kann hier festgehalten werden, dass die mechanischen Eigenschaften einer Verbindung zwischen einer Anschlussdose und einer Photovoltaikpaneele bezüglich einer Auszugskraft durch die Anordnung eines separaten mechanischen Sicherungselementes verbessert wurden.

### BEZUGSZEICHENLISTE

- 1: Photovoltaikpaneele
- 2: Anschlussdose
- 3: unteres Solarglas
- 4: Zwischenschicht
- 5: oberes Solarglas
- 6: elektrische Leiter
- 7: Oberfläche
- 8: Anschlussdosengehäuse
- 9: Innenraum
- 10: externe Kontaktabschnitt
- 11: Anschlussabschnitt
- 12: interner Kontaktabschnitt
- 13: erstes Kontaktelement
- 14: erstes Kontaktelement
- 15: Buchsenelement
- 16: Steckerelement
- 17: Kontaktlamelle
- 18: mechanisches Sicherungselement
- 19: Federklipp
- 20: Flanschabschnitt
- 21: Buchsenabschnitt
- 22: Aufnahmeöffnung
- 23: Öffnung
- 24: Oberfläche

- 25: Kunststoffschicht
- 26: Kontaktstift
- 27: erstes Ende
- 28: zweites Ende
- 29: Verbindungsstelle
- 30: Halterungsöffnungen
- 31: Kontaktlasche
- 32: Kontaktlasche
- 33: zylindrischer Innenraum
- 34: Stift
- 35: Einhakabschnitte
- 36: Seitenwand
- 37: Innenraum
- 38: Ausnehmung
- 39: Anschlagsfläche
- 40: Stirnfläche
- 41: vordere Anschlagsfläche
- 42: hintere Anschlagsfläche
- 43: Spalt
- 44: Ausschnitt
- F: Auszugskraft
- M: Mittelachse

## Patentansprüche

1. Photovoltaisches Solarmodul umfassend eine Photovoltaikpaneele (1) und mindestens eine Anschlussdose (2),
wobei die Photovoltaikpaneele (1) mindestens ein Solarglas (3), eine unter dem Solarglas angeordnete Solarzelle (4) zur Gewinnung von elektrischer Energie und elektrische Leiter (6) zur Wegführung der Energie umfasst,
wobei die Anschlussdose (2) mindestens einen externen Kontaktabschnitt (10) zur Verbindung der Anschlussdose (2) mit externen Verbindungselementen zur Wegführung der elektrischen Energie umfasst, und
wobei der mindestens eine externe Kontaktabschnitt (10) der Anschlussdose (2) mit einem elektrischen Leiter (6) der Photovoltaikpaneele (1) über einen internen Kontaktabschnitt (12) elektrisch in Verbindung steht,
**dadurch gekennzeichnet,**
**dass** der interne Kontaktabschnitt (12) ein mit elektrischen Leiter (6) in Verbindung stehendes erstes Kontaktelement (13) und ein mit dem externen Kontaktabschnitt (10) in Verbindung stehendes zweites Kontaktelement (14) umfasst, wobei die elektrisch leitende Verbindung zwischen dem ersten und dem zweiten Kontaktelement (13, 14) durch eine Buchsen-Stecker-Verbindung mit einem Buchsenelement (15) und einem Steckerelement (16) bereitgestellt wird, und
**dass** die Buchsen-Stecker-Verbindung (15, 16) durch ein mechanisches Sicherungselement (18,19) gegen unbeabsichtigtes Trennen der Verbindung gesichert ist.

2. Photovoltaisches Solarmodul nach Anspruch 1, **dadurch gekennzeichnet, dass** das mechanische Sicherungselement (18, 19) vom Buchsenelement (15) und/oder vom Steckerelement (16) separat ausgebildet ist, wobei das Sicherungselement (18, 19) vorzugsweise zwischen Buchsenelement (15) und Steckerelement (16) zu liegen kommt, wenn das Steckerelement (16) im Buchsenelement (15) eingeführt ist.

3. Photovoltaisches Solarmodul nach einem der vorhergehenden Ansprüche, **dadurch gekennzeichnet, dass** das Sicherungselement (18, 19) zwischen dem Buchsenelement (15) und dem Steckerelement (16) eine formschlüssige Verbindung und/oder eine kraftschlüssige Verbindung bereitstellt.

4. Photovoltaisches Solarmodul nach einem der vorhergehenden Ansprüche, **dadurch gekennzeichnet, dass** das Steckerelement (16) eine umlaufende Ausnehmung (38) mit einer Anschlagsfläche (40) umfasst, wobei das Sicherungselement (18, 19) in dieser Ausnehmung (38) liegt, und dass das Buchsenelement (15) mindestens eine Halterungsöffnung (30) aufweist, welche der Aufnahme von mindestens einem Einhakabschnitt (35) des Sicherungselementes (18) dient, wobei eine auf das Steckerelement (16) wirkende Auszugskraft (F) über die Anschlagsfläche auf das Sicherungselement (18, 19) übertragbar ist, und wobei diese Auszugskraft (F) vom Sicherungselement (18, 19) über den mindestens einen Einhakabschnitt (35) auf die Halterungsöffnung (30) und somit auf das Buchsenelement (15) übertragbar ist.

5. Photovoltaisches Solarmodul nach einem der vorhergehenden Ansprüche, **dadurch gekennzeichnet, dass** das Buchsenelement (15) mit der Photovoltaikpaneele in Verbindung steht und derart angeordnet ist, dass die Halterungsöffnungen (30) von der Oberfläche (7) des Solarglases (5) zugänglich sind.

6. Photovoltaisches Solarmodul nach einem der vorhergehenden Ansprüche, **dadurch gekennzeichnet, dass** das Steckerelement (16) mit dem Gehäuse (8) der Anschlussdose (2) in Verbindung steht, wobei das Steckerelement (16) vorzugsweise fest im Gehäuse (8) gelagert ist bzw. fest mit dem Gehäuse (8) verbunden ist, so dass die Anschlussdose (2) steckbar mit der Photovoltaikpaneele (1) verbindbar ist.

7. Photovoltaisches Solarmodul nach einem der vorhergehenden Ansprüche, **dadurch gekennzeichnet, dass** sich das Buchsenelement (15) durch eine Öffnung (23) im Solarglas (5) durch das Solarglas (5) hindurch erstreckt, wobei sich das Buchsenelement (15) insbesondere über die Oberfläche (7) des Solarglases (5) erstreckt, so dass das Buchsenelement (15) von der Oberfläche (7) hervorsteht.

8. Photovoltaisches Solarmodul nach einem der vorhergehenden Ansprüche, **dadurch gekennzeichnet, dass** das Buchsenelement (15) des internen Kontaktabschnittes (12) über eine elektrisch leitende stoffschlüssige Verbindung mit dem elektrischen Leiter (6) der Photovoltaikpaneele (1) in Verbindung steht.

9. Photovoltaisches Solarmodul nach einem der vorhergehenden Ansprüche, **dadurch gekennzeichnet, dass** das Buchsenelement (15) einen Flanschabschnitt (20) und einen sich dem Flanschabschnitt (20) anschliessenden Buchsenabschnitt (21) mit einer sich entlang einer Achse erstreckenden Aufnahmeöffnung (22) aufweist, wobei der Flanschabschnitt (20) der elektrischen Verbindung mit dem elektrischen Leiter (6) und der Buchsenabschnitt (21) der Aufnahme sowie der elektrischen Verbindung des bzw. mit dem Steckerelement (16) dient.

10. Photovoltaisches Solarmodul nach einem der vorhergehenden Ansprüche, **dadurch gekennzeichnet, dass** sich Teile des Buchsenelementes (15), insbesondere der Flanschabschnitt (20) von der Öffnung (23) im Solarglas (5) auf dessen zur Photovoltaikpaneele zugewandten Oberfläche (24) entlang derselben radial erstrecken, so dass diese Teile einen Anschlag gegen eine Krafteinwirkung (F) entlang der Mittelachse (M) des Buchsenelementes (15) bereitstellen.

11. Photovoltaisches Solarmodul nach einem der vorhergehenden Ansprüche, **dadurch gekennzeichnet, dass** zwischen Buchsenelement (15) und der Öffnung (23) im Solarglas (5) eine Kunststoffschicht (25) angeordnet ist, wobei die Kunststoffschicht (25) insbesondere aus einem Kunststoff ausgewählt aus der Gruppe der Copolymere ist, wobei der Kunststoff bevorzugt Ethylenvinylacetat ist.

12. Photovoltaisches Solarmodul nach einem der vorhergehenden Ansprüche, **dadurch gekennzeichnet, dass** zwischen dem internen Kontaktabschnitt (12), insbesondere zwischen dem Steckerelement (16) und dem externen Kontaktabschnitt (10) mindestens ein elektrisches und/oder elektronisches Funktionselement, insbesondere einer Bypassdiode, angeordnet ist, wobei das mindestens eine Funktionselement mit dem internen Kontaktabschnitt (12) und dem externen Kontaktabschnitt (10) elektrisch leitend in Verbindung steht.

13. Photovoltaisches Solarmodul nach einem der vorhergehenden Ansprüche, **dadurch gekennzeichnet, dass** das Buchsenelement (15) in die Photovoltaikpaneele (1) einlaminiert ist.

14. Photovoltaisches Solarmodul nach einem der vorhergehenden Ansprüche, **dadurch gekennzeichnet, dass** die Anschlussdose (2) zusätzlich zur mechanischen Verbindung zwischen Buchsenelement (15) und Steckerelement (16) mit einem Klebstoff auf die Oberfläche (7) der Photovoltaikpaneele (1) aufgeklebt ist, wobei der Klebstoff vorzugsweise den Spalt (43) zwischen Anschlussdose (2) und Photovoltaikpaneele (1) abdichtet.

15. Photovoltaisches Solarmodul nach einem der vorhergehenden Ansprüche, **dadurch gekennzeichnet, dass** zwischen Buchsenelement (15) und Steckerelement (16) eine Kontaktlamelle (17) zur Vermittelung eines elektrischen Kontaktes zwischen Buchsenelement (15) und Steckerelement (16) angeordnet ist.
